# EUROPÄISCHE PATENTSCHRIFT

(11) **EP 1 950 574 B1**
(45) Veröffentlichungstag und Bekanntmachung des Hinweises auf die Patenterteilung: **14.03.2012**
(21) Anmeldenummer: 08000945.9
(22) Anmeldetag: 18.01.2008
(51) Int. Cl.: G01R 15/18, G01R 15/20, G01R 19/20

(54) **Vorrichtung zur Messung eines durch einen elektrischen Leiter fliessenden elektrischen Stroms**
Device for measuring a current flowing through an electric conductor
Dispositif de mesure d'un courant électrique passant dans un conducteur électrique

(30) Priorität: 25.01.2007 DE 102007003830
(43) Veröffentlichungstag der Anmeldung: 30.07.2008
(73) Patentinhaber: Robert Seuffer GmbH & Co. KG, 75365 Calw (DE)
(72) Erfinder: Dudzik, Rainer, 75394 Oberreichenbach (DE)
(74) Vertreter: Eisenführ, Speiser & Partner

(56) Entgegenhaltungen:
- EP-A2- 0 947 846
- US-A1- 2003 017 753
- PARANJAPE M ET AL: "A 3-D VERTICAL HALL MAGNETIC-FIELD SENSOR IN CMOS TECHNOLOGY*" SENSORS AND ACTUATORS A, ELSEVIER SEQUOIA S.A., LAUSANNE, CH LNKD- DOI:10.1016/0924-4247(92)80133-N, Bd. A34, Nr. 1, 1. Juli 1992 (1992-07-01), Seiten 9-14, XP000297419 ISSN: 0924-4247

## Beschreibung

Die Erfindung betrifft eine Vorrichtung zur Messung eines durch einen elektrischen Leiter fließenden elektrischen Stroms mit einer in der Nähe des elektrischen Leiters angeordneten Messeinrichtung, welche das vom elektrischen Strom erzeugte Magnetfeld erfasst und ein der Stromstärke entsprechendes elektrisches Signal liefert.

Zur berührungslosen Erfassung eines in einem elektrischen Leiter fließenden Stromes ist es bekannt, magnetfeldempfindliche Sensoren insbesondere in Überstromschutzeinrichtungen zum Einsatz zu bringen (DD 257 719 A1).

Die Druckschrift US 2003/017753 A1 offenbart eine Batterieklemme mit einem integrierten Stromsensor, wobei über die Messung eines Magnetfelds auf einen durch den elektrischen Leiter fließenden und das Magnetfeld erzeugenden Strom geschlossen wird. Der Stromsensor kann mit dem entsprechenden Batteriepol zur Messung des Stroms in einem galvanischen Kontakt stehen oder kann mit einem Stromsensor auf der Basis eines Hall-Sensors ausgebildet sein. Die Ausgangssignale des Hall-Sensors werden ausgewertet, und es kann in Abhängigkeit von dem Ausgangssignal der durch den elektrischen Leiter fließende Strom bestimmt werden.

Die Druckschrift "A 3-D vertical Hall magnetic-field sensor in CMOS technology" von Paranjape, Filanovsky und Ristic, Sensors and Actuators A, veröffentlicht Juli 1992 (XP 000297419), offenbart die Anordnung eines Sensors, der als Stromsensor oder allgemein als ein Magnetfeldsensor verwendet werden kann. Ein zu erfassendes Magnetfeld, das in einem dreidimensionalen Raum ausgebildet ist, wird mittels des Magnetfeldsensors in allen drei Dimensionen erfasst, so dass eine jeweilige Komponente des Magnetfelds in drei Raumrichtungen X, Y und Z gebildet wird. Der Magnetfeldsensor umfasst für die dreidimensionale Erfassung des Magnetfelds jeweilige Hall Sensoren, mit denen eine der Komponenten erfasst wird. Die Ausgangssignale der jeweiligen Hall-Sensoren bezeichnen eine in dieser Raumrichtung herrschende Magnetfeldintensität. Es sind unterschiedliche Ausführungsformen des Magnetfeldsensors vorgesehen, wobei in Abhängigkeit von der Ausführung unterschiedliche Messungen und Ergebnisse möglich sind. Gegenseitige Beeinflussungen der jeweiligen Messergebnisse in bestimmten Raumrichtungen durch andere Raumrichtungen sollen vermieden oder reduziert werden.

Demgegenüber liegt der Erfindung die Aufgabe zugrunde, eine Vorrichtung der eingangs genannten Art derart auszugestalten, dass eine genaue Messung des im elektrischen Leiter fließenden elektrischen Stroms erreicht wird.

Diese Aufgabe wird durch die im Anspruch 1 angegebenen Merkmale gelöst. Die Unteransprüche beinhalten vorteilhafte Weiterbildungen der Erfindung.

Bei der Erfindung kommt eine Messeinrichtung zum Einsatz, welche in der Nähe des elektrischen Leiters angeordnet wird und welche das vom stromdurchflossenen Leiter erzeugte Magnetfeld in drei orthogonalen Raumrichtungen erfassen kann. Hierzu besitzt die Magnetsensoreinrichtung den drei orthogonalen Raumrichtungen zugeordnete Magnetfeld-empfindliche Wandler oder Sensoren. Diese geben zu den drei orthogonalen Feldstärkekomponenten des Magnetfeldes proportionale elektrische Signale ab.

In bevorzugter Weise weist die Messeinrichtung wenigstens einen Kern aus magnetischen Material mit wenigstens einem Luftspalt auf, in welchem ein der Stromstärke entsprechendes Magnetfeld erzeugt wird. Die Magnetsensoreinrichtung ist im wenigsten einen Luftspalt oder in der Nähe des Luftspaltes zur Erfassung des erzeugten Magnetfeldes angeordnet.

Im Luftspalt kann durch entsprechende Formgebung der den Luftspalt begrenzenden Grenzflächen ein homogenes oder inhomogenes Magnetfeld erzeugt werden.

Hierbei ist es möglich, dass die in den orthogonalen Raumrichtungen jeweils gemessenen Magnetfeldstärken Messbereichen mit unterschiedlichen Messempfindlichkeiten zugeordnet werden. Ferner ist es möglich, in mehreren Luftspalten Messeinrichtungen anzuordnen und die jeweiligen Messeinrichtungen Messbereichen mit unterschiedlichen Messempfindlichkeiten zuzuordnen. Auch ist es möglich, verschiedene Bereiche der Magnetisierungskurve des Magnetmaterials Messbereichen mit unterschiedlicher Messempfindlichkeit zuzuordnen. Es können Kerne vorgesehen sein, welche mehrere Luftspalte aufweisen. Jedoch ist es auch möglich, mehrere Kerne vorzusehen, zwischen denen mehrere Luftspalte gebildet werden. Ferner können Kerne aus unterschiedlichen Magnetmaterialien vorgesehen sein. Dabei kann der jeweilige Kern wenigstens einen Luftspalt aufweisen und es kann zwischen den Kernen zumindest ein Luftspalt gebildet werden. Bei dieser Anordnung können ebenfalls in den Luftspalten oder in der Nähe der Luftspalten Messeinrichtungen die unterschiedlichen Messbereichen zugeordnet sind, vorgesehen sein. Der stromführende elektrische Leiter oder die stromführenden elektrischen Leiter können durch Bohrungen und/oder Ausnehmungen des wenigstens einen Kerns geführt sein. Auch ist es möglich, den Leiter um den Kern oder um am Kern oder anderen Kernteil vorgesehene Vorsprünge zu führen.

In bevorzugter Weise ist die Vorrichtung so ausgebildet, dass sie an einem Stromanschlusselement, beispielsweise an einer Kabelschelle oder Polanschlussklemme für Batteriepole in Fahrzeugen geeignet ist.

Die Magnetsensoreinrichtung enthält den orthogonalen Raumrichtungen zugeordnete magnetfeldempfindliche Wandler, beispielsweise magnetoresistive Wandler, Hallelemente, Magnetotransistoren oder dergleichen.

Anhand der Figuren wird an Ausführungsbeispielen die Erfindung noch näher erläutert. Es zeigt:
Figur 1 in schematischer Darstellung ein Ausführungsbeispiel der Erfindung;
Figuren 2 bis 5 unterschiedlich geformte Luftspalte im magnetischen Kreis des in Figur 1 dargestellten Ausführungsbeispiels;
Figur 6 beim Beispiel einer Magnetisierungskurve für ein Material des magnetischen Kreises; und
Figur 7 eine Polanschlussklemme mit eingebautem Ausführungsbeispiel.

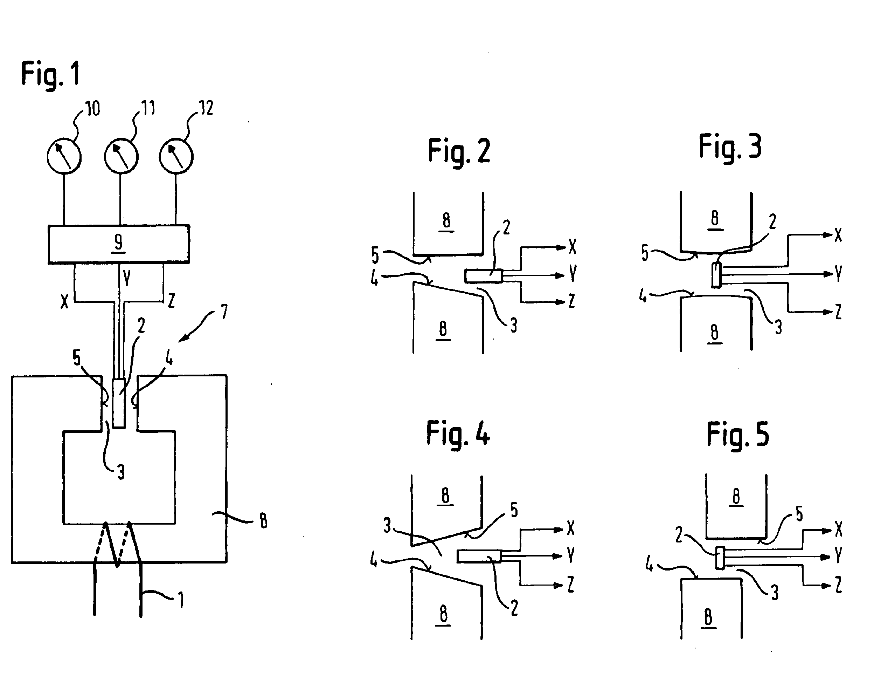

In Figur 1 ist schematisch eine Ausführungsbeispiel der Erfindung dargestellt. Dieses Ausführungsbeispiel beinhaltet einen magnetischen Kreis 8, welcher von einem Kern aus magnetischem Material gebildet wird. Es können magnetisch harte oder weiche Werkstoffe, insbesondere Ferrite als magnetisches Material für den magnetischen Kreis 8 verwendet werden. In der Figur 1 ist der magnetische Kreis rechteckig dargestellt. Es ist auch möglich, Ringkerne zur Bildung des magnetischen Kreises zu verwenden. Anstelle eines einfachen magnetischen Kreises können auch verzweigte magnetische Kreise zum Einsatz kommen.

Im magnetischen Kreis 8 ist beim Ausführungsbeispiel ein Luftspalt 3 vorhanden. Es können auch zwei oder mehrere Luftspalte im Magnetkreis vorgesehen sein. Der jeweilige Luftspalt 3 wird von Begrenzungsflächen 4 und 5 begrenzt. Durch entsprechende Formgebung der Grenzflächen 4 und 5 können im Luftspalt 3 homogene oder inhomogene Magnetfelder gebildet werden. Das im jeweiligen Luftspalt 3 gebildete Magnetfeld ist proportional zu einem Strom, insbesondere Gleichstrom, welcher in einem elektrischen Leiter 1 fließt. Der magnetische Kreis 8 ist in der Nähe dieses elektrischen Leiters 1 so angeordnet, dass die Feldlinien des vom elektrischen Leiter 1 gebildeten Magnetfeldes den magnetischen Kreis 8 durchfluten. Beim dargestellten Ausführungsbeispiel umschlingt der elektrische Leiter 1 einen Schenkel des magnetischen Kreises 8 in Form einer Spule. Bei Verwendung eines Ringkernes zur Bildung des magnetischen Kreises 8 kann der elektrische Leiter 1 durch eine Bohrung des Ringkernes geführt sein. Es ist auch möglich, den Leiter 1 in Ausnehmungen insbesondere in Ausnehmungen des Ringkernes in Form einer Schleife oder Spule anzuordnen.

Im Inneren des Luftspaltes 3 kann durch ebene, parallel zueinanderverlaufende Begrenzungsflächen 4 und 5 ein im Wesentlichen homogenes Magnetfeld erzeugt werden. Am Rand des Luftspaltes 3 ist das Magnetfeld inhomogen und die Feldlinien haben einen gekrümmten Verlauf.

In bevorzugter Weise wird im Luftspalt 3 ein inhomogenes Magnetfeld gebildet. Hierzu können die Begrenzungsflächen 4 und 5 unterschiedliche Formen aufweisen. Beim Ausführungsbeispiel der Figur 2 ist eine der beiden Begrenzungsflächen schräg gegenüber der anderen Begrenzungsfläche angeordnet. Beim Ausführungsbeispiel der Figur 3 haben die Begrenzungsflächen 4 und 5 gekrümmte, insbesondere Karlottenform, wobei an Stelle der in der Figur 3 dargestellten konvexen Krümmung auch eine konkave Krümmung zum Einsatz kommen kann.

Beim Ausführungsbeispiel der Figur 4 sind beide Begrenzungsflächen 4 und 5 schräg gegenüber der mittleren Ebene des Luftspaltes 3 angeordnet. Beim Ausführungsbeispiel der Figur 5 sind die beiden ebenen Begrenzungsflächen 4 und 5 versetzt zueinander angeordnet. Je nach Anwendungszweck können auch andere Formen der Begrenzungsflächen zum Einsatz kommen, wobei eine kombinierte Anwendung der in den Figuren 2 bis 5 dargestellten Anordnungen ebenfalls zum Einsatz kommen kann.

Es können zur Bildung des magnetischen Kreises 8 Kerne aus unterschiedlichen magnetischen Materialien zum Einsatz kommen. Der jeweilige Luftspalt 3 kann im Kernmaterial oder zwischen benachbarten Kernen gebildet werden.

Im Luftspalt 3 wird bei der Strommesseinrichtung 7 eine Magnetsensoreinrichtung 2 angeordnet, welche das Magnetfeld in drei orthogonalen Raumrichtungen (X Y Z) erfasst. Hierzu besitzt die Magnetsensoreinrichtung den drei orthogonalen Raumrichtungen (X Y Z) zugeordnete magnetfeldempfindliche Wandler oder Sensoren. Jeder dieser Sensoren erzeugt ein elektrisches Signal, welches der Magnetfeldkomponente in der ihm zugeordneten Raumrichtung proportional ist. Diese Signale werden einer Auswerteeinrichtung 9 insbesondere elektronischen Auswerteeinrichtung, beispielsweise Mikroprozessor zugeleitet. Diese wertet die elektrischen Signale aus und bildet Anzeigesignale für Anzeigeeinrichtungen 10, 11, 12. Diese Anzeigeeinrichtungen können den drei orthogonalen Raumrichtungen zugeordnete Anzeigen liefern.

In bevorzugter Weise wird die Magnetfeldsensoreinrichtung 2 in einem inhomogen Magnetfeldbereich des Luftspaltes 3 angeordnet. Wie oben schon erläutert, können der Luftspalt beziehungsweise die Luftspalte so ausgebildet sein, dass inhomogene Magnetfelder erzeugt werden. Wenn die Anzeigeeinrichtungen 10, 11, 12 den jeweiligen Raumrichtungen (X Y Z) der Feldstärkekomponenten zugeordnet sind, werden unterschiedliche Messwerte in den Anzeigeeinrichtungen für den im elektrischen Leiter 1 fließenden Strom angegeben. Bei Änderung des im elektrischen Leiter fließenden Stromes ergeben sich bei den Anzeigeeinrichtungen 10, 11, 12 auch unterschiedliche Änderungen. Dies resultiert daraus, dass bei einer Stromänderung die Änderungen der in den jeweiligen Raumrichtungen liegenden Feldstärkekomponenten des Magnetfeldes am Ort der zugeordneten Wandler beziehungsweise Sensoren der Magnetsensoreinrichtung 2 sich unterschiedlich ändern. Für die Messungen in den drei Raumrichtungen ergeben sich daher unterschiedliche Stromempfindlichkeiten bei den Messwerten und den jeweiligen Anzeigen für diese Messwerte.

Auch bei der Begrenzung der mehreren Luftspalten durch unterschiedliche magnetische Materialien an den Grenzflächen 4 und 5 können unterschiedliche Messempfindlichkeiten bei Stromstärkeänderungen des im elektrischen Leiter 1 fließenden elektrischen Stromes bewirkt werden. Es ist möglich, die Anzeige mit der jeweils gewünschten Messempfindlichkeit einzuschalten.

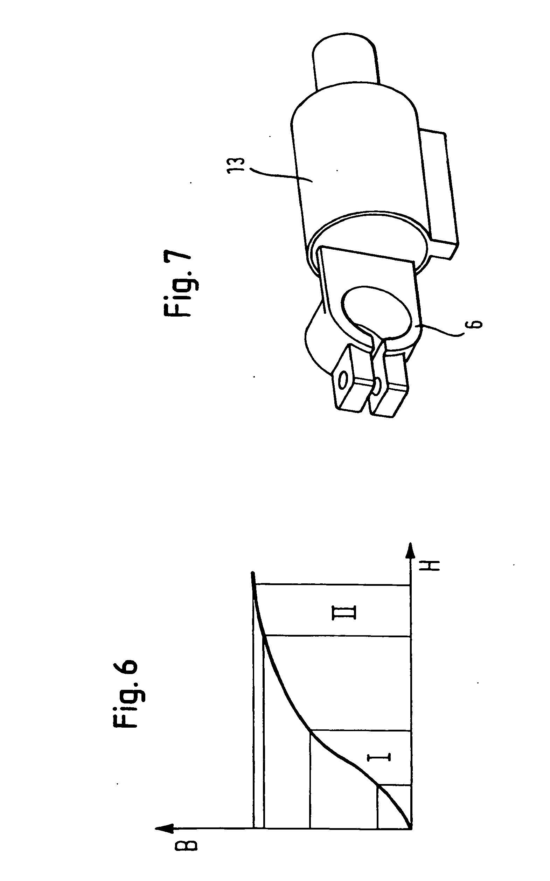

Ferner ist es möglich die Strommessungen in unterschiedlichen Bereichen der Magnetisierungskurve durchzuführen. Beispielsweise erreicht man in einem Bereich (I) bei einer relativ großen Stromänderung und damit verbundener Magnetflussänderung eine nur relativ geringe Änderung der Magnetfeldstärke. Bei Annäherung an den Sättigungsbereich läuft die Magnetisierungskurve flacher, so dass eine relativ geringe Stromänderung im Bereich (II) eine große Magnetfeldänderung bewirkt, wie aus der Figur 6 zu ersehen ist.

In Figur 7 ist eine Polanschlussklemme 6 für ein Stromversorgungskabel, welches an einen Batteriepol einer Fahrzeugbatterie anzuschließen ist, gezeigt. In einem Gehäuse 13 ist ein Ausführungsbeispiel der Erfindung eingebaut und an der Polanschlussklemme 6 befestigt. Dieses Ausführungsbeispiel ist stellvertretend für weitere Einsatzmöglichkeiten der erfindungsgemäßen Vorrichtung bei der Anordnung in unmittelbarer Nähe von stromdurchflossenen Leitern, deren Stromstärke zu messen ist. Wie das Ausführungsbeispiel zeigt, kann die erfindungsgemäße Vorrichtung in einem Gehäuse, insbesondere im Bereich von Stromanschlusselementen, befestigt werden.

### Bezugszeichenliste

- 1.: Elektrischer Leiter
- 2.: Magnetsensoreinrichtung
- 3.: Luftspalt
- 4.: Grenzfläche
- 5.: Grenzfläche
- 6.: Polanschlussklemme
- 7.: Elektrische Strommesseinrichtung
- 8.: Magnetischer Kreis
- 9.: Auswerteeinrichtung
- 10. -12.: Anzeigeeinrichtungen
- 13.: Gehäuse

## Patentansprüche

1. Vorrichtung zur Messung eines durch einen elektrischen Leiter fließenden elektrischen Stromes mit einer in der Nähe des elektrischen Leiters angeordneten Messeinrichtung, welche das vom elektrischen Strom erzeugte Magnetfeld erfasst und ein der Stromstärke entsprechendes elektrisches Signal liefert, **dadurch kennzeichnet, dass** die Messeinrichtung eine das Magnetfeld in drei orthogonalen Raumrichtungen erfassende Magnetsensoreinrichtung (2) aufweist, wobei die Magnetsensoreinrichtung (2) den drei orthogonalen Raumrichtungen (X, Y, Z) zugeordnete magnetfeldempfindliche Wandler oder Sensoren aufweist, und die in den orthogonalen Raumrichtungen (X, Y, Z) gemessenen Magnetfeldstärken jeweils Messbereichen mit unterschiedlichen Messempfindlichkeiten zugeordnet sind.

2. Vorrichtung nach Anspruch 1,
**dadurch gekennzeichnet, dass** die Messeinrichtung (7) wenigstens einen magnetischen Kreis (8) aus magnetischem Material mit wenigstens einem Luftspalt (3) aufweist, in welchem ein der Stromstärke entsprechendes Magnetfeld erzeugt wird, und dass die Magnetsensoreinrichtung (2) im wenigstens einen Luftspalt (3) oder in der Nähe des Luftspaltes (3) zur Erfassung des im Luftspalt (3) oder in der Nähe des Luftspaltes (3) vorhandenen Magnetfeldes angeordnet ist.

3. Vorrichtung nach Anspruch 2,
**dadurch gekennzeichnet, dass** die den Luftspalt (3) begrenzenden Flächen eines den magnetischen Kreis (8) bildenden Kernes Grenzflächen (4 und 5) zur Erzeugung eines homogenen Magnetfeldes im Luftspalt (3) sind.

4. Vorrichtung nach Anspruch 2,
**dadurch gekennzeichnet, dass** die den Luftspalt (3) begrenzenden Grenzflächen (4 und 5) zur Erzeugung eines inhomogenen Magnetfeldes im Luftspalt (3) ausgebildet sind.

5. Vorrichtung nach einem der Ansprüche 2 bis ,
**dadurch gekennzeichnet, dass** in oder in der Nähe von mehreren Luftspalten (3) verschiedenen Messbereichen mit unterschiedlichen Messempfindlichkeiten zugeordnete Magnetsensoreinrichtungen (2) vorgesehen sind.

6. Vorrichtung nach einem der Ansprüche 2 bis 5,
**dadurch gekennzeichnet, dass** den verschiedenen Bereichen der Sättigungskurve des jeweiligen Magnetmaterials des wenigstens einen magnetischen Kreises (8) Messbereiche mit unterschiedlichen Messempfindlichkeiten zugeordnet sind.

7. Vorrichtung nach einem der Ansprüche 2 bis 6,
**dadurch gekennzeichnet, dass** zwei oder mehr Kerne zur Bildung des magnetischen Kreises (8) vorgesehen sind und zwischen den Kernen eine oder mehrere Luftspalte (3) gebildet sind.

8. Vorrichtung nach Anspruch 7,
**dadurch gekennzeichnet, dass** die Kerne aus unterschiedlichen Magnetmaterialien gebildet sind.

9. Vorrichtung nach einem der Ansprüche 1 bis 8,
**dadurch gekennzeichnet, dass** der stromführende elektrische Leiter (1) durch Bohrungen und/oder Ausnehmungen oder um Vorsprünge wenigstens eines Kerns geführt ist, in welchem das Magnetfeld erzeugt wird.

10. Vorrichtung nach einem der Ansprüche 1 bis 9,
**dadurch gekennzeichnet, dass** sie geeignet ist zur Befestigung an einem Stromanschlusselement insbesondere Kabelschelle oder Polanschlussklemme, insbesondere für Fahrzeugbatterien.

## Claims

1. Apparatus for measuring an electric current flowing through an electrical conductor, comprising a measuring device which is arranged in the proximity of the electrical conductor and which detects the magnetic field generated by the electric current and supplies an electrical signal corresponding to the current strength, **characterised in that** the measuring device has a magnetic sensor device (2) detecting the magnetic field in three orthogonal spatial directions, wherein the magnetic sensor device (2) has magnetic field-sensitive transducers or sensors associated with the three orthogonal spatial directions (X, Y, Z) and the magnetic field strengths measured in the orthogonal spatial directions (X, Y, Z) are respectively associated with measuring regions of different measurement sensitivities.

2. Apparatus according to claim 1 **characterised in that** the measuring device (7) has at least one magnetic circuit (8) of magnetic material with at least one air gap (3), in which a magnetic field corresponding to the current strength is generated and the magnetic sensor device (2) is arranged in the at least one air gap (3) or in the proximity of the air gap (3) for detecting the magnetic field present in the air gap (3) or in the proximity of the air gap (3).

3. Apparatus according to claim 2 **characterised in that** the surfaces, defining the air gap (3), of a core which forms the magnetic circuit (8) are boundary surfaces (4 and 5) for generating a homogeneous magnetic field in the air gap (3).

4. Apparatus according to claim 2 **characterised in that** the boundary surfaces (4 and 5) defining the air gap (3) are adapted to generate a nonhomogeneous magnetic field in the air gap (3).

5. Apparatus according to one of claims 2 to 4 **characterised in that** magnetic sensor devices (2) associated with various measuring regions involving different measurement sensitivities are provided in or in the proximity of a plurality of air gaps (3).

6. Apparatus according to one of claims 2 to 5 **characterised in that** measuring regions of different measurement sensitivities are associated with the various regions of the saturation curve of the respective magnetic material of the at least one magnetic circuit (8).

7. Apparatus according to one of claims 2 to 6 **characterised in that** there are provided two or more cores for forming the magnetic circuit (8) and one or more air gaps (3) are formed between the cores.

8. Apparatus according to claim 7 **characterised in that** the cores are formed from different magnetic materials.

9. Apparatus according to one of claims 1 to 8 **characterised in that** the current-carrying electrical conductor (1) is passed through bores and/or openings or around projections of at least one core in which the magnetic field is generated.

10. Apparatus according to one of claims 1 to 9 **characterised in that** it is suitable for fixing to a current connecting element, in particular a cable clamp or a pole connecting terminal clamp, in particular for vehicle batteries.

## Revendications

1. Dispositif pour la mesure d'un courant électrique circulant à travers un conducteur électrique comprenant un équipement de mesure disposé à proximité du conducteur électrique, lequel détecte le champ magnétique produit par le courant électrique et délivre un signal électrique correspondant à l'intensité du courant, **caractérisé en ce que** l'équipement de mesure présente un équipement à capteur magnétique (2) détectant le champ magnétique dans trois directions spatiales orthogonales, l'équipement à capteur magnétique (2) présentant des convertisseurs ou des capteurs sensibles au champ magnétique associés aux trois directions spatiales orthogonales (X, Y, Z), et les intensités de champ magnétique mesurées dans les directions spatiales orthogonales (X, Y, Z) étant associées respectivement à des plages de mesure avec différentes sensibilités de mesure.

2. Dispositif selon la revendication 1,
**caractérisé en ce que** l'équipement de mesure (7) présente au moins un circuit magnétique (8) en matériau magnétique comprenant au moins un entrefer (3), dans lequel un champ magnétique correspondant à l'intensité de courant est produit, et que l'équipement à capteur magnétique (2) est disposé dans au moins un entrefer (3) ou à proximité de l'entrefer (3) pour détecter le champ magnétique présent dans l'entrefer (3) ou à proximité de l'entrefer (3).

3. Dispositif selon la revendication 2,
**caractérisé en ce que** les surfaces délimitant l'entrefer (3) d'un noyau formant le circuit magnétique (8) sont des surfaces limites (4 et 5) pour produire un champ magnétique homogène dans l'entrefer (3).

4. Dispositif selon la revendication 2,
**caractérisé en ce que** les surfaces limites (4 et 5) délimitant l'entrefer (3) sont conçues pour produire un champ magnétique inhomogène dans l'entrefer (3).

5. Dispositif selon l'une quelconque des revendications 2 à 4,
**caractérisé en ce que** des équipements à capteur magnétique (2) associés à différentes plages de mesure comprenant différentes sensibilités de mesure sont disposés dans plusieurs entrefers (3) ou à proximité de ces derniers.

6. Dispositif selon l'une quelconque des revendications 2 à 5,
**caractérisé en ce que** des plages de mesure comprenant différentes sensibilités de mesure sont associées aux différentes plages de la courbe de saturation du matériau magnétique respectif du ou des circuits magnétiques (8).

7. Dispositif selon l'une quelconque des revendications 2 à 6,
**caractérisé en ce que** deux noyaux ou plus sont prévus pour former le circuit magnétique (8) et un ou plusieurs entrefers (3) sont formés entre les noyaux.

8. Dispositif selon la revendication 7,
**caractérisé en ce que** les noyaux sont réalisés en des matériaux magnétiques différents.

9. Dispositif selon l'une quelconque des revendications 1 à 8,
**caractérisé en ce que** le conducteur électrique en charge (1) est guidé à travers des trous et/ou des évidements ou autour de saillies d'au moins un noyau dans lequel est produit le champ magnétique.

10. Dispositif selon l'une quelconque des revendications 1 à 9,
**caractérisé en ce qu'**il convient à la fixation sur un élément de raccordement électrique, en particulier à un collier de câble ou à une borne de raccordement de pôle, en particulier pour des batteries de véhicule.
